# EUROPEAN PATENT APPLICATION

(11) **EP 2 709 157 A2**
(43) Date of publication of application: **19.03.2014**
(21) Application number: 13181368.5
(22) Date of filing: 22.08.2013
(51) Int. Cl.: H01L 29/778, H01L 21/336, H01L 29/51, H01L 23/29, H01L 29/423, H01L 29/20

(54) **Heterostructure transistor with multiple gate dielectric layers**

(30) Priority: 14.09.2012 US 201213617584
(71) Applicant: Power Integrations, Inc., San Jose, California 95138 (US)
(72) Inventor: Ramdani, Jamal, Raritan, NJ New Jersey 08869 (US); Murphy, Michael, Middlesex, NJ New Jersey 08846 (US); Liu, Linlin, Hillsborough, NJ New Jersey 08844 (US)
(74) Representative: Schley, Jan Malte

(57) **Abstract**

A heterostructure semiconductor device includes a first active layer (102) and a second active layer (106) disposed on the first active layer. A two-dimensional electron gas layer (104) is formed between the first and second active layers. A first gate dielectric layer (108) is disposed on the second active layer. A second gate dielectric layer (110) is disposed on the first gate dielectric layer. A passivation layer (112) is disposed over the second gate dielectric layer. A gate (114) extends through the passivation layer to the second gate dielectric layer. First and second ohmic contacts (116, 118) electrically connect to the second active layer. The first and second ohmic contacts are laterally spacedapart, with the gate being disposed between the first and second ohmic contacts.

## Description

### TECHNICAL FIELD

The present invention relates generally to high-voltage field effect transistors (FETs); more specifically, to high-electron-mobility transistors (HEMTs) and heterostructure field-effect transistors (HFETs), and to methods of fabricating such power transistor devices.

### BACKGROUND

One type of high-voltage FET is a heterostructure FET (HFET), also referred to as a high-electron mobility transistor (HEMT). HFETs based on gallium nitride (GaN) and other wide bandgap nitride III based direct transitional semiconductor materials, such as silicon carbide (SiC), are advantageously utilized in certain electronic devices due to their superior physical properties over silicon-based devices. For example, GaN and AlGaN/GaN transistors are commonly used in high-speed switching and high-power applications (e.g., power switches and power converters) due to the high electron mobility, high breakdown voltage, and high saturation electron velocity characteristics offered by GaN-based materials and device structures. Due to the HFETs physical properties, HFETs may change states substantially faster than other semiconductor switches that conduct the same currents at the same voltages and the wide bandgap may improve performance of the HFET at elevated temperatures.

GaN-based HFETs devices typically include a gate member formed over a thin gate dielectric (e.g., oxide) material. In the past, interface states between the gate oxide and underlying GaN layers have played a major role in the stability and electrical reliability of GaN-based HFETs. Improving the gate stability is necessary to achieve high voltage operations (e.g., 600 V). Typical prior art HFET gate structures include Schottky gates, which have no gate oxide, or a single, thin gate oxide layer. These structures suffer from low critical voltage usually in the range of 20-40 V. The critical voltage, V_{CRIT}, is defined as the gate-to-source voltage, V_{GS}, at which there is a relatively sharp rise in the gate leakage current.

Properties of the gate dielectric also affect other parameters and characteristics of the HFET. For example, the thickness of the gate dielectric layer plus the thickness of the underlying barrier layer partially determine the gate threshold voltage of a high-voltage HFET. Whereas a thicker gate dielectric reduces gate leakage current with increased temperature or increased applied gate voltage, the thickness of the gate dielectric contributes to the threshold voltage. As such, a trade-off exists between thermal and voltage stability versus the ability to provide a constant threshold voltage for the HFET device.

### BRIEF DESCRIPTION OF THE DRAWINGS

Non-limiting and non-exhaustive embodiments of the present invention are described with reference to the following figures, wherein like reference numerals refer to like parts throughout the various views unless otherwise specified.

**FIG. 1** is a cross-sectional side view of an example semiconductor device having a multiple-layer, gate dielectric structure.

**FIG. 2** is a diagram illustrating an example process flow for fabricating a semiconductor device having a multiple-layer, gate dielectric structure.

**FIG. 3** is a diagram illustrating another example process flow for fabricating a semiconductor device having a multiple-layer, gate dielectric structure.

**FIG. 4** is a graph illustrating example gate leakage increases versus applied gate voltage for various semiconductor devices.

Corresponding reference characters indicate corresponding components throughout the several views of the drawings. Skilled artisans will appreciate that elements in the figures are illustrated for simplicity and clarity and have not necessarily been drawn to scale. For example, the dimensions of some of the elements in the figures may be exaggerated relative to other elements to help to improve understanding of various embodiments of the present invention. Also, common but well-understood elements that are useful or necessary in a commercially feasible embodiment are often not depicted in order to facilitate a less obstructed view of these various embodiments of the present invention.

### DETAILED DESCRIPTION

In the following description, numerous specific details are set forth in order to provide a thorough understanding of the present invention. It will be apparent, however, to one having ordinary skill in the art that the specific detail need not be employed to practice the present invention. In other instances, well-known materials or methods have not been described in detail in order to avoid obscuring the present invention.

Reference throughout this specification to "one embodiment", "an embodiment", "one example" or "an example" means that a particular feature, structure or characteristic described in connection with the embodiment or example is included in at least one embodiment of the present invention. Thus, appearances of the phrases "in one embodiment", "in an embodiment", "one example" or "an example" in various places throughout this specification are not necessarily all referring to the same embodiment or example. Furthermore, the particular features, structures or characteristics may be combined in any suitable combinations and/or sub-combinations in one or more embodiments or examples. Particular features, structures or characteristics may be included in an integrated circuit, an electronic circuit, a combinational logic circuit, or other suitable components that provide the described functionality. In addition, it is appreciated that the figures provided herewith are for explanation purposes to persons ordinarily skilled in the art and that the drawings are not necessarily drawn to scale.

As used herein, the "critical voltage" or "critical gate voltage" of a HFET device is defined as the gate-to-source voltage at which there is a relatively sharp rise in the gate leakage current. Thermal stability relates to how much the gate leakage current of the device increases with temperature.

As mentioned above, typical HFET gate structures include Schottky gates, which have no gate oxide, or a single, thin gate oxide layer. These structures suffer from low critical voltage usually in the range of 20-40 V. The critical voltage, V_{CRIT}, is defined as the gate-to-source voltage, V_{GS}, at which there is a relatively sharp rise in the gate leakage current. To achieve high reliability and high gate oxide integrity, the critical voltage needs to be increased from the present range of 20-40 V. Further, devices with a single, thin gate oxide layer may experience an increase in gate leakage current two or three times larger than the leakage current at room temperature when the device is operating at high temperatures (such as 120 degrees Celsius).

In accordance with embodiments of the present invention, a GaN-based HFET device and method of fabricating the same is disclosed which includes a multi-layer gate dielectric structure. In one embodiment, the HFET device has first and second active layers with a two-dimensional electron gas layer forming therebetween. A first gate dielectric layer is disposed on the second active layer. Nitride-based compounds such as silicon nitride (SiN), carbon nitride (CN) or boron nitride (BN) may be utilized for first gate dielectric layer 108. A second gate dielectric layer is disposed on the first gate dielectric layer. In one example, aluminum oxide (Al₂O₃) may be used for the second gate dielectric layer. A gate is disposed on the second gate dielectric layer. Ohmic contacts (source and drain) of the device extend through the first and second gate dielectric layers.

In various embodiments this multiple gate dielectric structure may result in very high critical voltage operation (e.g., >80 V). Further, a device utilizing a multiple gate dielectric structure may experience improved thermal stability. The device may experience substantially no change in the leakage current when the device is operating at temperatures upwards to 200 degrees Celsius. In addition to producing a more stable and robust gate dielectric structure, other benefits observed include lower gate leakage and a more uniform gate threshold voltage. The multi-layer gate dielectric structure also allows the HFET device to maintain a constant threshold voltage while minimizing gate leakage current.

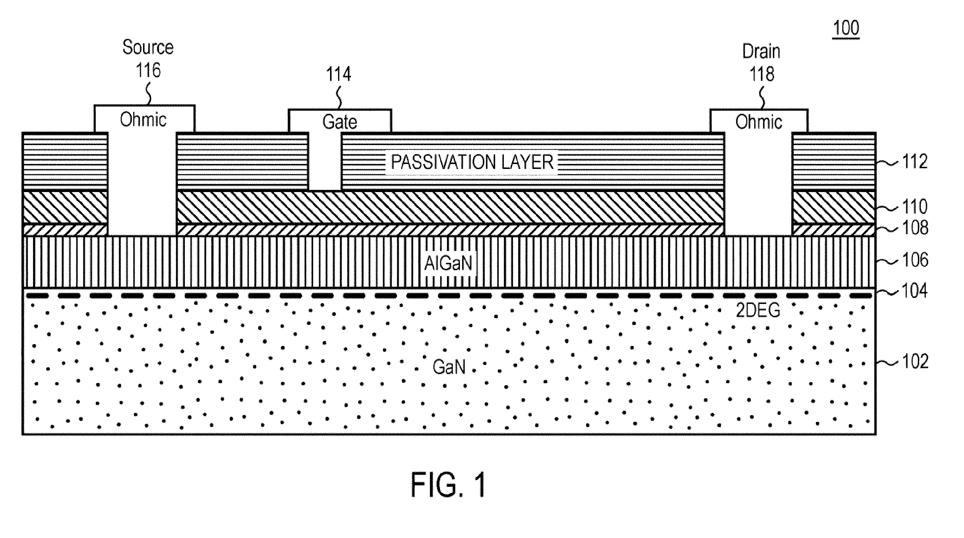

In one embodiment, an Atomic Layer Deposition (ALD) reaction chamber technique is utilized to form a thin layer of a nitride compound (e.g., SiN) in-situ over active transistor device layers, immediately followed by a thin Al₂O₃ deposition by ALD. The term "in-situ" refers to a process that is carried out within a single tool or reaction chamber without exposing the wafer to the environment outside the tool or chamber. Further, the term "ex-situ" may refer to a process that is not carried out in a single tool. First gate dielectric 108 may also be deposited using metal-organic chemical vapor decomposition (MOCVD). Further, the first gate dielectric 108 may be deposited in-situ with the first and second active layers 102 and 106, respectively. In another embodiment, first gate dielectric 108 may be deposited ex-situ from the respective first and second active layers 102 and 106 through atomic layer deposition (ALD). As configured in FIG. 1, the multi-layer gate dielectric structure includes a Al₂O₃ layer disposed atop of a Si₃N₄ layer.

In the descriptions below, an example HFET is used for the purpose of explanation. However, it should be appreciated that embodiments of the present invention may be utilized with other types of FETs, such as a metal oxide semiconductor FET (MOSFET) or metal insulator semiconductor FET (MISFET) devices.

FIG. 1 illustrates a cross-sectional side view of a semiconductor device 100 (e.g., a GaN HFET) which includes a first active layer 102, a second active layer 106, a first gate dielectric 108, a second gate dielectric 110, a passivation layer 112, ohmic contacts 116 and 118, and gate 114. Further shown in FIG. 1 is a layer of electrical charge layer 104 which may form between the first active layer 102 and the second active layer 106 due to the bandgap difference between the two layers. The layer of electrical charge layer 104 defines the lateral conductive channel which is sometimes called a two-dimensional electron gas (2DEG) layer 104 because electrons, trapped in a quantum well that results from the bandgap difference between the first and second active layer 102 and 106 are free to move in two dimensions but are tightly confined in the third dimension. Further, the first active layer 102 is sometimes called a channel layer while the second active layer 106 is sometimes called the barrier layer or donor layer.

The second active layer 106 is disposed on first active layer 102. First gate dielectric layer 108 is disposed on second active layer 106. A second gate dielectric layer 110 is disposed on first gate dielectric layer 108. A passivation layer 112 is disposed on second gate dielectric layer 110. A gate 114 extends vertically down through passivation layer 112 to second gate dielectric layer 110. Respective source and drain ohmic contacts 116 & 118 are shown extending vertically down through passivation layer 112, second gate dielectric layer 110, and first gate dielectric layer 108 to electrically connect to second active layer 106. As shown, source and drain ohmic contacts 116 & 118 are laterally spaced-apart, with gate 114 being disposed between source and drain ohmic contacts 116 & 118.

It is appreciated that first active layer 102 is typically disposed over a substrate (not shown) formed of any one of a number of different materials, such as sapphire (Al₂O₃), silicon (Si), GaN, or silicon carbide (SiC). In one embodiment, first active layer 102 comprises an epitaxial GaN layer. To avoid possible problems with lattice mismatch and/or differences in thermal coefficients of expansion, one or more additional layers may be disposed between the substrate and first active layer 102. For example, an optional thin nucleation layer may be formed between the substrate and first active layer 102. In other examples, first active layer 102 may comprise different semiconductor materials containing nitride compounds of other Group III elements. The first active layer 102 may be grown or deposited on the substrate.

In the example of FIG. 1 second active layer 106 comprises aluminum gallium nitride (AlGaN). In other examples, different Group III nitride semiconductor materials such as aluminum indium nitride (AlInN) and aluminum indium gallium nitride (AlInGaN) may be used for second active layer 106. In other embodiments, the material of second active layer 106 may be a non-stoichiometric compound. In such materials, the ratios of the elements are not easily represented by ordinary whole numbers. For example, the second active layer 106 may be a non-stoichiometric compound of a Group III nitride semiconductor material such as Al_{X}Ga_{1-X}N, where 0<X<1. The second active layer 106 may be grown or deposited on the first active layer 102.

Also shown in FIG. 1 is a first gate dielectric layer 108 disposed on the second active layer 106. In one embodiment, first gate dielectric layer 108 comprises silicon nitride (SiN). In other embodiments, first gate dielectric layer 108 may comprise Si₃N₄. In still other examples, different nitride-based compounds such as carbon nitride (CN) or boron nitride (BN) may be utilized for first gate dielectric layer 108. The first gate dielectric layer 108 may be a nitride based material which may conserve the atomic arrangement with the second active layer 106. Further, the first gate dielectric layer 108 may be insulating and have a band gap of at least 3 electron volts (eV). In one example, the thickness of first gate dielectric layer 108 may be substantially between 1-5 nanometers (nm) thick. First gate dielectric layer may be deposited in-situ with first and second active layers 102 and layer 106, respectively. First gate dielectric 108 may be deposited using metal-organic chemical vapor decomposition (MOCVD). In another embodiment, first gate dielectric 108 may be deposited ex-situ from first and second active layers 102 & 106 through atomic layer deposition (ALD).

As shown, second gate dielectric layer 110 disposed on first gate dielectric layer 108. In one example, second gate dielectric layer 110 comprises aluminum oxide (Al₂O₃). In still further examples, other oxide materials, such as ZrO, HfO, SiO₂ and GdO, may be utilized for the second gate dielectric layer 110. In one embodiment, second gate dielectric layer 110 has a thickness in the range of approximately 10-20 nm thick. In one embodiment, the second gate dielectric layer 110 is thicker than the first gate dielectric layer 108. For example, the thickness of first gate dielectric layer may be in a range of approximately 10-50 angstroms (A). In one example fabrication process, second gate dielectric layer 110 may be deposited ex-situ from respective first and second active layers 102 &106 utilizing atomic layer deposition (ALD).

Passivation layer 112 is disposed on second gate dielectric layer 110 and laterally surrounds ohmic contacts 116, 118, and gate 114. In one embodiment, passivation layer 112 may comprise a dielectric material such as silicon nitride (SiN). In further embodiments, passivation layer 112 may comprise multiple layers of material. Passivation layer 112 provides stability of the electrical characteristics of the device by isolating the surface of the device from electrical and chemical contaminants of the environment. Passivation layer 112 may be deposited through chemical vapor deposition such as low pressure chemical vapor deposition (LPCVD) or plasma-enhanced chemical vapor deposition (PECVD).

First and second gate dielectric layers 108 & 110 separate gate 114 from second active layer 106. As shown, gate 114 is disposed through passivation layer 112 to contact second gate dielectric layer 110. In one embodiment, gate 114 comprises a gold nickel (NiAu) alloy. In another embodiment, gate 114 comprises a titanium gold (TiAu) alloy or molybdenum gold MoAu alloy. In other examples, gate 114 may comprise a gate electrode and gate field plate. In operation, gate 114 controls the forward conduction path between ohmic source and drain contacts 116 & 118. In an example fabrication process, gate 114 may be formed by etching an opening in passivation layer 112, followed by a gate metal deposition. In the example of FIG. 1, the portion of gate 114 which is above passivation layer 112 and extends laterally towards ohmic drain contact 118 serves as a gate field plate, which functions to alleviate the electric field intensity at an edge (closest to ohmic contact 118).

Ohmic contacts 116 and 118 are disposed through passivation layer 112, second gate dielectric layer 110, and first gate dielectric layer 108 to contact the second active layer 106. Ohmic contact 116 is one example of a source contact, while ohmic contact 118 is one example of a drain contact. In one embodiment, ohmic contacts 116 and 118 may be formed by etching openings in passivation layer 112, second gate dielectric layer 110, and first gate dielectric layer 108, followed by a metal deposition and annealing steps. In another example fabrication process, ohmic contacts 116 and 118 may be formed before the deposition of second gate dielectric layer 110 and passivation layer 112.

As shown, FIG. 1 illustrates the device structure at a point in the fabrication process just after formation of ohmic metal contacts 116 and 118, which respectively comprise source and drain electrodes of GaN HFET device 100. FIG. 1 shows ohmic metal contacts 116 and 118 formed directly on the second active layer 106. In other embodiments, ohmic metal contacts 116 and 113 may be formed in recesses which extend vertically downward into the second active layer 106. In other embodiments, ohmic metal contacts 116 and 118 may be formed in recesses that extend vertically downward through second active layer 106 to contact the first active layer 102.

When HFET device 100 is configured for use as a power switch, gate 114 and ohmic contacts 116 & 118 are typically coupled through terminals to form electrical connections to external circuits. In operation, electric charge in 2DEG layer 104 flows laterally between the ohmic contacts 116 and 118 to become a current in an external circuit. The electric charge flow, and hence the current, may be controlled by a voltage from an external circuit that is electrically connected between the gate 114 and ohmic contact 116.

As used in this disclosure, an electrical connection is an ohmic connection. An ohmic connection is one in which the relationship between the voltage and the current is substantially linear and symmetric for both directions of the current. For example, two metal patterns that contact each through only metal are electrically connected. In contrast, ohmic contacts 116 and 118 are not electrically connected to each other in HFET device 100 because any connection between these two contacts is through a channel in the semiconductor material, which conduction path is controlled by gate 114. Similarly, gate 114 is not electrically connected to second active layer 106 since first and second gate dielectric layers 108 and 110 insulate gate 114 from the underlying active layers.

In the embodiments described above, the thicknesses of the first and second gate dielectric layers 108 and 110 are such that the gate leakage current remains substantially constant over temperature during normal operation of HFET device 100. Stated differently, HFET device 100 does not experience any substantial change in gate leakage current when the device is operating at 120 °C. In addition, various embodiments of the present invention may operate up to 200 °C without significant changes to the gate leakage current.

Furthermore, the inventors have observed that the multiple gate dielectric layer structure described herein improves the voltage stability of the HFET device. For example, the critical voltage of HFET device 100 is significantly increased over prior art device structures to range of approximately 100-130 V.

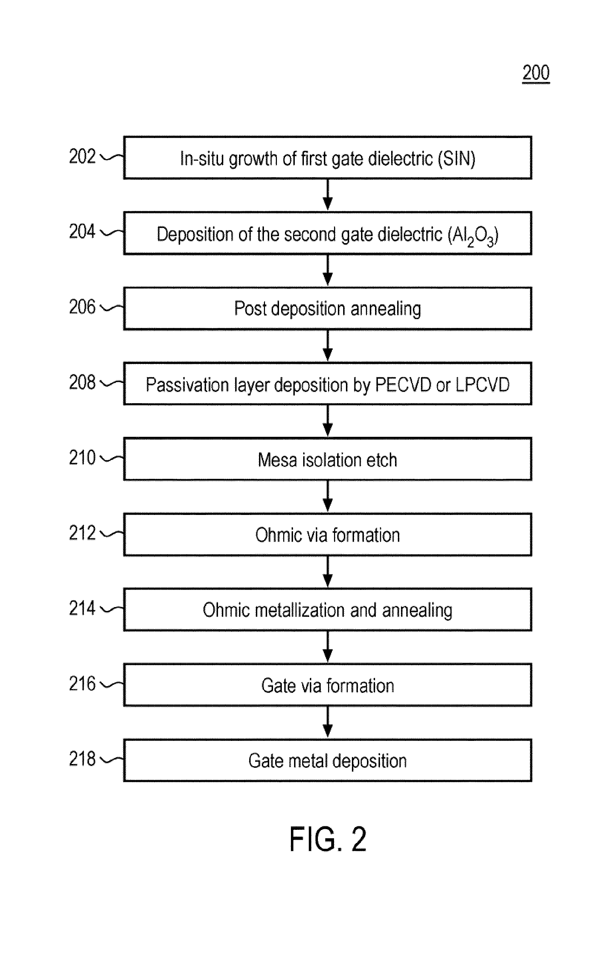

FIG. 2 is a diagram 200 illustrating an example process flow for fabricating a semiconductor device such as HFET device 100 shown in FIG. 1. In the example shown, the process starts after both the first and second active layer layers have been deposited or grown on a substrate. To begin, a first gate dielectric layer comprising SiN is grown in-situ (block 202). In one embodiment, the first gate dielectric layer is deposited using a MOCVD technique carried out at a temperature range between 800-1050 °C. The first gate dielectric layer is formed to a thickness of approximately 1-5 nm, and is continuous over the surface of the wafer. In one embodiment, the thickness of the gate dielectric layer is about 4 nm. In another embodiment, the first gate dielectric layer is formed in-situ with the first and second active layers. For example, the same machine (MOCVD) that is used to form the first and second active layers may also be used to form the first gate dielectric layer. In other embodiments the first gate dielectric layer may be deposited ex-situ from the first and second active layers.

Next, at block 204, the second gate dielectric layer is deposited atop the first gate dielectric layer. In one embodiment, the second gate dielectric layer is deposited on the wafer surface ex-situ from the first gate dielectric layer, and the first and second active layers, at 300 °C using ALD. In one embodiment, the second gate dielectric layer is deposited using ALD with an Al(CH₃)₃ precursor and O₂ plasma. The second gate dielectric layer is formed to a thickness in a range of approximately 10-20 nm. In a specific implementation, the second gate dielectric layer is about 15 nm thick.

In another embodiment, the first and second gate dielectric layers may be deposited ex-situ from the first and second active layers. For example, both the first and second gate dielectric layers may be deposited on the wafer surface using the same ALD chamber.

The process continues at block 206, at which point the second gate dielectric layer undergoes high temperature annealing to improve the film and interface quality of the second gate dielectric layer. By way of example, the annealing step may be performed in a furnace at temperature range of 450-750 °C for approximately 5-10 minutes. Annealing may also be performed using a number of different tools, such as a rapid temperature annealing (RTA) tool.

After annealing, a passivation layer is deposited over the second gate dielectric layer (block 208). In one embodiment, the passivation layer may be deposited using PECVD. The passivation layer may also be deposited using LPCVD. The passivation layer is typically formed to a thickness in a range of approximately 100-150 nm. As discussed above, the passivation layer may comprise silicon nitride (SiN) or other materials having similar properties.

At block 210, the surface of the passivation layer 112 undergoes mesa isolation etching to define the active region of the ohmic contacts 116 and 118. In other words, mesa isolation etching defines the footprint of the ohmic contacts 116 and 118. The mesa isolation may be performed utilizing a reactive-ion etching (RIE) system. Further, the mesa isolation may be performed using inductively coupled plasma (ICP) RIE.

Following mesa isolation, ohmic source and drain contacts are formed through the passivation layer, second gate dielectric layer, and first gate dielectric layer (block 212). This involves first forming openings through the afore-mentioned layers, and then depositing a metal or metal alloy to fill the openings. In one example fabrication sequence, the metal utilized for the ohmic contacts is deposited using e-beam metal evaporation. An example ohmic contact metal is TiAlMoAu. The metal ohmic contacts are then annealed utilizing a RTA tool at a temperature range of approximately 600-900 °C (block 214).

The gate may be formed in a similar manner as the ohmic contacts. That is, the gate may be formed by first etching an opening though passivation layer to expose the second gate dielectric layer (block 216). In one embodiment, dry etching is performed utilizing a gas such as CF₄ or SF₆. After the etching process exposes the second gate dielectric layer, a gate metal or metal alloy deposition (block 218) is performed to fill the etched opening. In one example, NiAu is used as the gate metal. As shown in FIG. 1, a field plate portion may be formed by masking or etching the gate metal such that a top portion laterally extends over the passivation layer towards the farthest (drain) ohmic contact.

Persons of ordinary skill in the semiconductor arts will understand that other standard post-fabrication or back-end processing steps may be performed, including forming metal (e.g., patterned lines or traces) on the surface of the wafer, wafer backgrinding (also called backlapping or wafer thinning), die separation, and packaging.

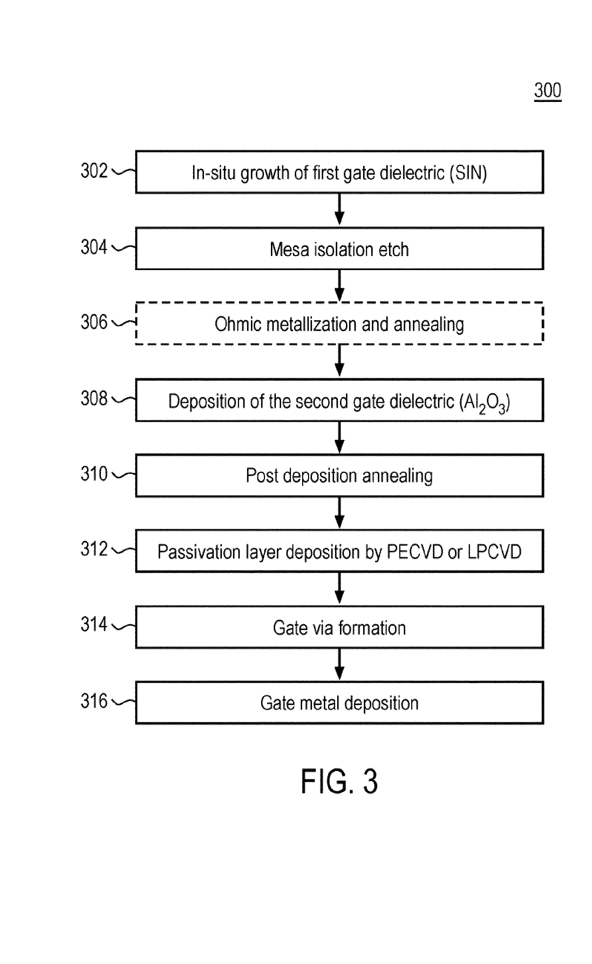

FIG. 3 is a diagram 300 illustrating another example process flow for fabricating a HFET semiconductor device having a multiple-layer, gate dielectric structure. Flow diagram 300 is similar to flow diagram 200 except the process for forming the ohmic contacts occurs prior to passivation.

The process begins after the first active layer and second active layer are deposited or grown on a substrate. At block 302, the first gate dielectric layer is deposited in-situ. The first gate dielectric layer may be deposited using MOCVD at a temperature range between 800 to 1050 °C. The thickness of the first gate dielectric layer 108 is substantially between 1-5 nm and is continuous over the surface of the wafer. In one embodiment, the thickness of the gate dielectric layer is 4 nm. However, similar to mentioned above, the first gate dielectric layer may be deposited ex-situ from the first and second active layers. Further, the first gate dielectric layer may be deposited in the same machine as the second gate dielectric layer.

After growth of the first gate dielectric, the surface of the first gate dielectric layer undergoes mesa isolation etching to define the active region of the ohmic contacts (block 304). The mesa isolation may be performed utilizing a reactive-ion etching (RIE) system. In other fabrication methods, the mesa isolation may be performed using inductively coupled plasma (ICP) RIE. At this point in the process flow, ohmic via openings may optionally be formed through the first gate dielectric layer, followed by ohmic metallization and annealing at 850 °C for about one minute (block 306).

Next, the second gate dielectric layer is deposited on the first gate dielectric layer (block 310). The second gate dielectric layer may also be deposited over the source and drain ohmic contacts. In one embodiment, the second gate dielectric layer is deposited on the wafer surface using ALD at 300 °C. The second gate dielectric layer may be grown to a thickness of approximately 10-20 nm. In one embodiment, the deposition of the second gate dielectric layer may be performed ex-situ from the first and second active layers.

A high temperature anneal may be performed after the second gate dielectric layer has been deposited (block 312). The temperature of the annealing may be between 500 to 700 °C and can be applied using either a furnace or a rapid temperature annealing (RTA) tool. This annealing step improves the film and interface quality of the second gate dielectric layer.

Following annealing a passivation layer is formed on the second gate dielectric layer (block 314). In one embodiment, the passivation layer may be deposited using PECVD. The passivation layer may also be deposited using LPCVD. The thickness of the passivation layer may be between about 100-150 nm thick. As mentioned above, the passivation layer may comprise silicon nitride (SiN).

Gate via formation is shown occurring next at block 316. This step is performed by masking and then etching passivation layer such that an opening is formed through the passivation layer, thereby exposing the second gate dielectric layer. In one embodiment, dry etching may be utilized with a gas such as CF₄ or SF₆ to etch through the passivation layer. At block 318, the gate metal is deposited in the gate via opening. In one example, NiAu is utilized as the gate metal. As shown in FIG. 1, the gate member includes a field plate portion that extends toward the drain ohmic contact. In one embodiment, the passivation layer and second gate dielectric layer may undergo further etching and metal deposition to include field plate portions for both ohmic contacts.

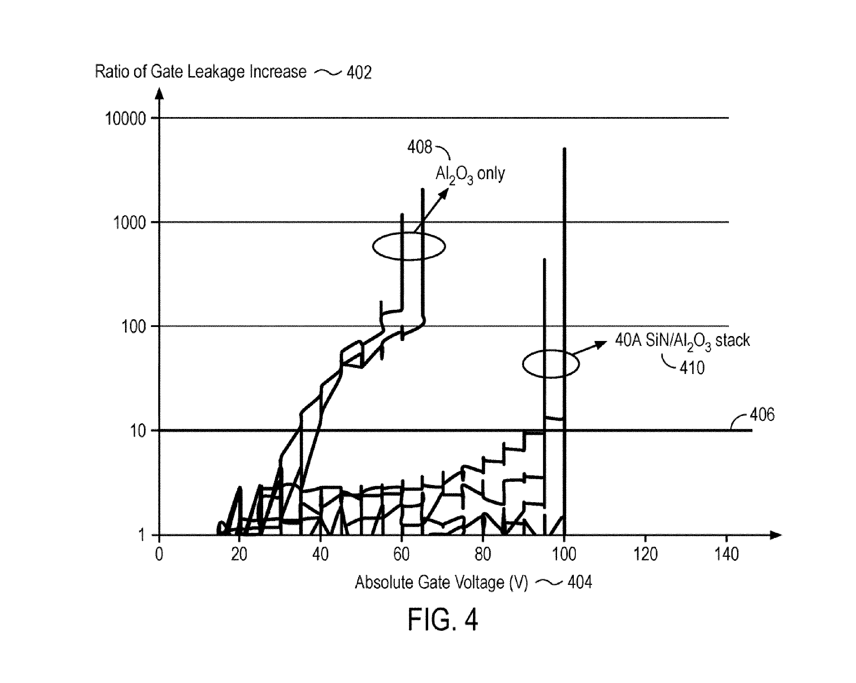

FIG. 4 is a graph illustrating example gate leakage increases versus applied gate voltage for various HFET devices each having different gate dielectric structures. As shown, the x-axis represents absolute gate voltage 404 while the y-axis is a ratio of gate leakage increase 402. The ratio of the gate leakage current shown on y-axis 402 represents the ratio of the leakage current of the device under stress to the leakage current of the device before stress. Graph 400 further shows a critical threshold level 406. The critical threshold 406 may be defined as the threshold where the ratio of gate leakage increase 402 is no longer acceptable and the device is considered in breakdown. For the example shown, the critical threshold 406 is substantially 10. In addition, the critical voltage refers to the gate voltage at which the ratio of gate leakage increase for the particular device reaches the critical threshold 406.

As shown, graph 400 illustrates the performance of a first group of devices 408, and a second group of devices 410. The gate voltage for each of the various groups of devices is increased while the ratio of gate leakage increase 402 is measured. For the first group of devices 408, the critical voltage is approximately 30-40 V. For the second group of devices 410, the critical voltage is approximately 95-100 V. The first group of devices 410 represents devices with a single gate dielectric layer (Al₂O₃) while the second group 410 represents devices with multiple gate dielectric layers. As illustrated, the second group of devices 410 represents devices that each has a first gate dielectric layer about 4 nm thick. As illustrated in FIG. 4, the critical voltage may be substantially increased when multiple gate dielectric layers are utilized in accordance with the embodiments of the present invention.

The above description of illustrated examples of the present invention, including what is described in the Abstract, are not intended to be exhaustive or to be limitation to the precise forms disclosed. While specific embodiments of, and examples for, the invention are described herein for illustrative purposes, various equivalent modifications are possible without departing from the broader spirit and scope of the present invention. Indeed, it is appreciated that the specific example voltages, thicknesses, material types, etc., are provided for explanation purposes and that other values may also be employed in other embodiments and examples in accordance with the teachings of the present invention.

### EMBODIMENTS

Although the present invention is defined in the attached claims, it should be understood that the present invention can also (alternatively) be defined in accordance with the following embodiments:
1. A heterostructure semiconductor device comprising:
   a first active layer;
   a second active layer disposed on the first active layer, a two-dimensional electron gas layer forming between the first and second active layers;
   a first gate dielectric layer disposed on the second active layer;
   a second gate dielectric layer disposed on the first gate dielectric layer;
   a passivation layer disposed over the second gate dielectric layer;
   a gate that extends through the passivation layer to the second gate dielectric layer;
   first and second ohmic contacts that electrically connect to the second active layer, the first and second ohmic contacts being laterally spaced-apart, the gate being disposed between the first and second ohmic contacts.
2. The heterostructure semiconductor device of embodiment 1 wherein the second gate dielectric layer comprises aluminum oxide (Al₂O₃).
3. The heterostructure semiconductor device of embodiment 1 wherein the first gate dielectric layer has a first thickness and the second gate dielectric has a second thickness, the second thickness being larger than the first thickness.
4. The heterostructure semiconductor device of embodiment 1 wherein the first gate dielectric layer comprises a nitride-based compound.
5. The heterostructure semiconductor device of embodiment 1 wherein the first gate dielectric layer comprises silicon nitride (SiN).
6. The heterostructure semiconductor device of embodiment 1 wherein the first gate dielectric layer comprises carbon nitride (CN).
7. The heterostructure semiconductor device of embodiment 1 wherein the first gate dielectric layer comprises boron nitride (BN).
8. The heterostructure semiconductor device of embodiment 1 wherein the first gate dielectric layer has a first thickness in a range of about 1-5 nanometers thick.
9. The heterostructure semiconductor device of embodiment 1 wherein the second gate dielectric has a second thickness in a range of about 10-20 nanometers thick.
10. The heterostructure semiconductor device of embodiment 1 wherein the first gate dielectric layer has a first thickness and the second gate dielectric has a second thickness, the first thickness and the second thickness are set such that a leakage current through the gate is substantially constant versus temperature during normal operation of heterojunction semiconductor device.
11. The heterostructure semiconductor device of embodiment 1 wherein the first gate dielectric layer has a first thickness and the second gate dielectric has a second thickness, the first thickness and the second thickness are set such that a threshold voltage is substantially constant versus temperature during normal operation of heterojunction semiconductor device.
12. The heterostructure semiconductor device according to embodiment 1 wherein the first active layer comprises gallium nitride (GaN).
13. The heterostructure semiconductor device of embodiment 1 wherein the second active layer comprises aluminum gallium nitride (AlGaN).
14. The heterostructure semiconductor device of embodiment 1 wherein the first and second active layers are defined as an isolated mesa.
15. The heterostructure semiconductor device of embodiment 1 wherein the gate comprises a gate metal.
16. The heterostructure semiconductor device of embodiment 15 wherein the gate metal comprises a nickel gold (NiAu) alloy.
17. The heterostructure semiconductor device of embodiment 15 wherein the gate metal includes a gate field plate that extends toward the drain ohmic contact.
18. The heterostructure semiconductor device of embodiment 1 wherein the passivation layer comprises silicon nitride (SiN).
19. The heterostructure semiconductor device of embodiment 1 wherein the gate metal comprises titanium gold (TiAu) alloy or molybdenum gold MoAu alloy.
20. A method of fabricating a heterostructure semiconductor device comprising:
   forming a first active layer on a substrate;
   forming a second active layer on the first active layer, the first active layer and the second active layer having different bandgaps such that a two-dimensional electron gas layer is formed therebetween;
   forming a first gate dielectric layer on the second active layer, the first gate dielectric layer having a first thickness;
   forming a second gate dielectric layer on the first gate dielectric layer, the second gate dielectric layer having a second thickness greater than the first thickness;
   forming first and second ohmic contacts that each extend vertically through the second gate dielectric layer, and the first gate dielectric layer, the first and second ohmic contacts being laterally spaced-apart and electrically connected to the second active layer; and
   forming a gate that contacts the second dielectric layer at a lateral position between the first and second ohmic contacts.
21. The method of embodiment 20 further comprising depositing, prior to the forming of the first and second ohmic contacts, a passivation layer over the second gate dielectric layer.
22. The method of embodiment 20 further comprising annealing the second gate dielectric layer.
23. The method of embodiment 20 further comprising annealing the first and second ohmic contacts.
24. The method of embodiment 20 wherein the first thickness and the second thickness are selected such that a gate leakage current remains substantially constant over temperature during a normal operation of the heterostructure semiconductor device.
25. The method of embodiment 20 wherein the first gate dielectric layer comprises silicon nitride.
26. The method of embodiment 20 wherein the second gate dielectric layer comprises aluminum oxide.
27. The method of embodiment 20 wherein the first active layer comprises gallium nitride.
28. The method of embodiment 20 wherein the second active layer comprises aluminum gallium nitride.
29. The method of embodiment 20 wherein the first gate dielectric layer is formed in-situ with the first and second active layers.
30. The method of embodiment 20 wherein the first gate dielectric layer is formed ex-situ with the first and second active layers.
31. The method of embodiment 20 wherein the first thickness is in a range of about 1-5 nanometers thick.
32. The method of embodiment 20 wherein the second thickness is in a range of about 10-20 nanometers thick.
33. The method of embodiment 20 wherein the forming of the second gate dielectric layer is performed using an Atomic Layer Deposition (ALD) reaction chamber with an Al(CH₃)₃ precursor and O₂ plasma.
34. The method of embodiment 20 wherein the forming of the first and second ohmic contacts comprises depositing a metal which includes gold (Au).
35. The method of embodiment 34 wherein the metal comprises TiAlMoAu.

## Claims

1. A heterostructure semiconductor device comprising:
a first active layer;
a second active layer disposed on the first active layer, a two-dimensional electron gas layer forming between the first and second active layers;
a first gate dielectric layer disposed on the second active layer;
a second gate dielectric layer disposed on the first gate dielectric layer;
a passivation layer disposed over the second gate dielectric layer;
a gate that extends through the passivation layer to the second gate dielectric layer;
first and second ohmic contacts that electrically connect to the second active layer, the first and second ohmic contacts being laterally spaced-apart, the gate being disposed between the first and second ohmic contacts.

2. The heterostructure semiconductor device of claim 1 wherein the second gate dielectric layer comprises aluminum oxide (Al₂O₃).

3. The heterostructure semiconductor device of claim 1 or 2 wherein the first gate dielectric layer has a first thickness and the second gate dielectric has a second thickness, the second thickness being larger than the first thickness.

4. The heterostructure semiconductor device of any of claims 1 to 3 wherein the first gate dielectric layer comprises a nitride-based compound, preferably silicon nitride (SiN), carbon nitride (CN) or boron nitride (BN).

5. The heterostructure semiconductor device of anyone of claims 1 to 4 wherein the first gate dielectric layer has a first thickness in a range of about 1-5 nanometers thick and wherein the second gate dielectric has a second thickness in a range of about 10-20 nanometers thick.

6. The heterostructure semiconductor device of any of the preceding claims wherein the first gate dielectric layer has a first thickness and the second gate dielectric has a second thickness, the first thickness and the second thickness are set such that a leakage current through the gate is substantially constant versus temperature during normal operation of heterojunction semiconductor device or such that a threshold voltage is substantially constant versus temperature during normal operation of heterojunction semiconductor device.

7. The heterostructure semiconductor device according to any of the preceding claims wherein the first active layer comprises gallium nitride (GaN) and wherein the second active layer comprises aluminum gallium nitride (AlGaN).

8. The heterostructure semiconductor device of any of the preceding claims wherein the first and second active layers are defined as an isolated mesa.

9. The heterostructure semiconductor device of any of the preceding claims wherein the gate comprises
a nickel gold (NiAu) alloy, titanium gold (TiAu) alloy or molybdenum gold MoAu alloy, preferably wherein the gate metal includes a gate field plate that extends toward the drain ohmic contact.

10. The heterostructure semiconductor device of any of the preceding claims wherein the passivation layer comprises silicon nitride (SiN).

11. A method of fabricating a heterostructure semiconductor device comprising:
forming a first active layer on a substrate;
forming a second active layer on the first active layer, the first active layer and the second active layer having different bandgaps such that a two-dimensional electron gas layer is formed therebetween;
forming a first gate dielectric layer on the second active layer, the first gate dielectric layer having a first thickness;
forming a second gate dielectric layer on the first gate dielectric layer, the second gate dielectric layer having a second thickness greater than the first thickness;
forming first and second ohmic contacts that each extend vertically through the second gate dielectric layer, and the first gate dielectric layer, the first and second ohmic contacts being laterally spaced-apart and electrically connected to the second active layer; and
forming a gate that contacts the second dielectric layer at a lateral position between the first and second ohmic contacts.

12. The method of claim 11 further comprising depositing, prior to the forming of the first and second ohmic contacts, a passivation layer over the second gate dielectric layer.

13. The method of claim 11 or 12 further comprising:
annealing the second gate dielectric layer; and
annealing the first and second ohmic contacts.

14. The method of anyone of claims 11 to 13 wherein the first gate dielectric layer is formed in-situ with the first and second active layers or wherein the first gate dielectric layer is formed ex-situ with the first and second active layers.

15. The method of anyone of claims 11 to 14 wherein the forming of the second gate dielectric layer is performed using an Atomic Layer Deposition (ALD) reaction chamber with an Al(CH₃)₃ precursor and O₂ plasma.
